# EUROPEAN PATENT SPECIFICATION

(11) **EP 4 457 530 B1**
(45) Date of publication and mention of the grant of the patent: **29.04.2026**
(21) Application number: 23835644.8
(22) Date of filing: 24.03.2023
(51) Int. Cl.: G01R 31/367, G01R 31/392, H02J 7/00

(54) **METHOD AND ELECTRONIC DEVICE FOR FORECASTING REMAINING USEFUL LIFE (RUL) OF BATTERY**
VERFAHREN UND ELEKTRONISCHE VORRICHTUNG ZUR VORHERSAGE DER VERBLEIBENDEN LEBENSDAUER EINER BATTERIE
PROCÉDÉ ET DISPOSITIF ÉLECTRONIQUE DE PRÉVISION DE DURÉE DE VIE UTILE RESTANTE (RUL) D'UNE BATTERIE

(30) Priority: 07.07.2022 IN 202241039119
(43) Date of publication of application: 06.11.2024
(73) Proprietor: SAMSUNG ELECTRONICS CO., LTD., Yeongtong-gu Suwon-si, Gyeonggi-do 16677 (KR)
(72) Inventor: SAHOO, Subhasmita, Bengaluru Karnataka 560037 (IN); HARIHARAN, Krishnan S, Bengaluru Karnataka 560037 (IN); AGARWAL, Samarth, Bengaluru Karnataka 560037 (IN); BRAHMADATHAN, Subramanian Swernath, Bengaluru Karnataka 560037 (IN); LEE, Sangheon, Suwon-si Gyeonggi-do 16677 (KR)
(74) Representative: Gulde & Partner
(86) International application number: PCT/KR2023/003970
(87) International publication number: WO 2024/010175

(56) References cited:
- CN-A- 113 406 525
- KR-A- 20220 065 709
- US-A1- 2016 209 472
- US-A1- 2016 209 472
- US-A1- 2017 205 466
- US-A1- 2017 205 466
- US-A1- 2021 190 877

## Description

### Technical Field

The disclosure relates to the field of a battery management methods and systems. More particularly, the disclosure relates to methods and electronic devices for forecasting remaining useful life (RUL) of a battery.

### Background Art

Over the years, health estimation of running cycle of a battery has received all the attention. Health trajectory forecasting for future cycles of the battery is gaining attention recently. Accurate and real-time prediction of battery health is high importance in prognosis. In addition, the health forecast of the battery should change if the battery is abused or anomaly happened. It should be robust to rapidly evolving battery types to reduce time-to-market.

Further, device-agnostic battery prognosis can be useful in advance scheduling of battery replacement, assessing used batteries for second-hand market, and evaluating batteries of competitors. For on-device prognosis, the method should be able to correct the advance health forecast after abuse/anomaly. The method must be device-agnostic so that the method can be used in any device. However, the existing methods do not support all above features.

Further, the existing methods are device specific (i.e., need parameter adjustment for every unseen device). The existing methods do not have a self-correcting mechanism (i.e., forecast once using limited data and do not change the forecast after abuse). The existing methods cannot detect level of abuse/anomaly (i.e., only detects if abused or not). In addition, the existing methods are not comprehensive (i.e., separate modules for different tasks, hence more computation intensive).

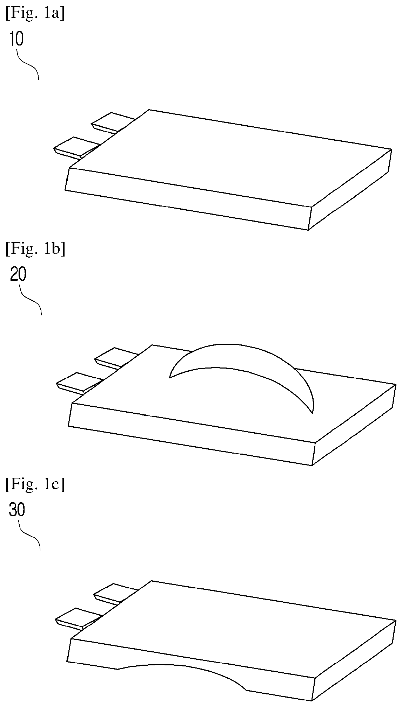

FIGS. 1A, 1B, and 1C are illustrations 10-30 in which various anomalies are depicted according to the related arts.

Referring to FIGS. 1A, 1B, and 1C, they illustrate a battery exposed to high temperature as shown in illustration 10 of FIG. 1A, swelling of the battery as shown in illustration 20 of FIG. 1B, and bending in the battery caused by a drop as shown in illustration 30 of FIG. 1C. All these anomalies are expected to have common impact on a RUL, such as sudden drop in state of health (SOH), battery capacity degrades faster and drop in the RUL.

The above information is presented as background information only to assist with an understanding of the disclosure. In US2016/0209472 A1, a method and apparatus for estimating battery life are provided. The method of estimating battery life involves estimating first status information of a battery based on battery information acquired from the battery, estimating second status information of the battery using a partial cycle model corresponding to a battery degradation pattern for a partial cycle, and calculating the battery life based on a comparison between the first status information and the second status information.

### Disclosure of Invention

### Technical Problem

Aspects of the disclosure are to address at least the above-mentioned problems and/or disadvantages and to provide at least the advantages described below. Accordingly, an aspect of the disclosure is to provide methods and an electronic device for forecasting RUL of a battery. The method can be used to estimate health, detect anomaly, and predict remaining useful life without requiring any parameter tuning for new electronic devices. The method can be used to forecast future health trajectory using initial few cycle information of the battery. The method can be used to provide an efficient health prediction for assessing fitness of used batteries in market and evaluating competitor batteries. The method supports the online implementation feasibly as it requires less computation. The method can be used to correct the forecasted health as battery ages. The method can be used to determine health, level of anomaly, remaining useful life of the battery at one place. Hence, the proposed method requires less computation. The method can be used to improve the user experience and avoids the surprise of the battery failure. The method can be used to ensure the user safety and avoid the accident by detecting anomaly. The method can be used to reduce the deployment time and effort, device agnostic approach.

Additional aspects will be set forth in part in the description which follows and, in part, will be apparent from the description, or may be learned by practice of the presented embodiments.

### Solution to Problem

The invention is defined by the independent claims. In accordance with an aspect of the invention, a method for forecasting remaining useful life (RUL) of a battery is provided. The method includes measuring, by an electronic device, at least one capacity value of the battery for each charging cycle of the battery and each discharging cycle of the battery, estimating, by the electronic device, at least one capacity value of the battery for subsequent charging cycles and subsequent discharging cycles using the at least one capacity value, wherein the at least one capacity value is provided to at least one of a battery capacity estimation model and a data driven model after a predefined number of charging cycles and a predefined number of discharging cycles, forecasting, by the electronic device, the RUL of the battery based on the at least one capacity value of the battery estimated by at least one of the battery capacity estimation model and the data driven model, and determining, by the electronic device, whether the at least one capacity value for the charging cycle and the discharging cycle is lower than the at least one capacity value estimated by at least one of the battery capacity estimation model and the data driven model. Further, the method includes correcting, by the electronic device, the forecasting RUL of the battery by feeding back the measured at least one capacity value to at least one of the battery capacity estimation model and the data driven model.

In an embodiment of the disclosure, further, the method includes detecting, by the electronic device, a level of the anomaly of the battery when the measured battery capacity value is lower than the estimated battery capacity value by at least one of the battery capacity estimation model and the data driven model.

In an embodiment of the disclosure, further, the method includes generating, by the electronic device, an alert including at least one of forecasted RUL, a battery replacement information, and a battery anomaly information based on the correction.

In an embodiment of the disclosure, the battery capacity estimation model is trained by a neural network using a charge cycle and a discharge cycle, wherein the battery capacity estimation model receives the charge cycle and the discharge cycle to compute a plurality of voltage, calculates a relative change in voltage from reference cycle of the battery and pass the plurality of voltage to a neural network to get a plurality of estimated SOH values.

In an embodiment of the disclosure, the RUL of the battery is forecasted as a number of charging cycles and discharging cycles subsequent to which the predicted battery capacity value is less than a predefined threshold.

In an embodiment of the disclosure, the RUL for the battery is forecasted in a connected environment.

In an embodiment of the disclosure, the RUL forecast continuously monitors a health of the battery and uses a feedback to correct the RUL forecast continuously.

In accordance with another aspect of the invention, an electronic device is provided. The electronic device includes a health, safety, and prognosis controller coupled with at least one processor and a memory. The health, safety, and prognosis controller is configured to measure at least one capacity value of the battery for each charging cycle of the battery and each discharging cycle of the battery, estimate at least one capacity value of the battery for subsequent charging cycles and subsequent discharging cycles using the at least one capacity value to at least one of a battery capacity estimation model and a data driven model after a predefined number of charging cycles and a predefined number of discharging cycles, forecast the RUL of the battery based on the at least one capacity value of the battery estimated by the at least one of the battery capacity estimation model and the data driven model, determine whether the at least one capacity value for the charging cycle and the discharging cycle is lower than the at least one capacity value estimated by at least one of the battery capacity estimation model and the data driven model, and correct the forecasting RUL of the battery by feeding back the measured at least one capacity value to at least one of the battery capacity estimation model and the data driven model.

Other aspects, advantages, and salient features of the disclosure will become apparent to those skilled in the art from the following detailed description, which, taken in conjunction with the annexed drawings discloses various embodiments of the disclosure.

### Brief Description of Drawings

The above and other aspects, features, and advantages of certain embodiments of the disclosure will be more apparent from the following description taken in conjunction with the accompanying drawings, in which:
FIGS. 1A, 1B, and 1C are illustrations in which various anomalies are depicted according to the related arts;
FIG. 2 illustrates various hardware components of an electronic device for forecasting RUL of a battery according to an embodiment of the disclosure;
FIG. 3 is a flowchart illustrating a method for forecasting a RUL of the battery according to an embodiment of the disclosure;
FIGS. 4, 5A, 5B, and 5C are graph illustrations in which an electronic device forecasts a RUL of a battery according to various embodiments of the disclosure;
FIGS. 6A and 6B are graph illustrations in which customized SOH estimator is depicted according to various embodiments of the disclosure;
FIGS. 6C and 6D are graph illustrations in which device-agnostic SOH estimation is depicted according to various embodiments of the disclosure;
FIGS. 6E and 6F are graph illustrations in which SOH forecast is depicted according to various embodiments of the disclosure;
FIGS. 7A, 7B, 7C, and 7D are illustrations in which battery health degrade is depicted based on Q-V, Q-I, and Q-Vr/SOC-Vr curve drift according to various embodiments of the disclosure;
FIGS. 8A and 8B are illustrations in which health trajectory of batteries cycled at different C-rates follow a pattern and start separating after initial few cycles according to various embodiments of the disclosure;
FIG. 9 is flowchart illustrating a method for forecasting a RUL of a battery according to an embodiment of the disclosure;
FIGS. 10A, 10B, 10C, 10D, 10E, 10F, 10G, 10H, and 10I are illustrations in which RUL of a battery is determined in connection with FIG. 9 according to various embodiments of the disclosure;
FIG. 11 is an illustration in which safe use of sensor networks is depicted according to related art; and
FIG. 12 is an illustration in which safe use of sensor networks is depicted according to an embodiment of the disclosure.

The same reference numerals are used to represent the same elements throughout the drawings.

### Best Mode for Carrying out the Invention

The following description with reference to the accompanying drawings is provided to assist in a comprehensive understanding of various embodiments of the disclosure as defined by the claims. It includes various specific details to assist in that understanding but these are to be regarded as merely exemplary. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

The embodiments herein achieve a method for forecasting RUL of a battery. The method includes measuring, by an electronic device, at least one capacity value of the battery for each charging cycle of the battery and each discharging cycle of the battery. Further, the method includes estimating, by the electronic device, at least one capacity value of the battery for subsequent charging cycles and subsequent discharging cycles using the at least one capacity value, wherein the at least one capacity value is provided to at least one of a battery capacity estimation model and a data driven model after a predefined number of charging cycles and a predefined number of discharging cycles. Further, the method includes forecasting, by the electronic device, the RUL of the battery based on the at least one capacity value of the battery estimated by at least one of the battery capacity estimation model and the data driven model. Further, the method includes determining, by the electronic device, whether the at least one capacity value for the charging cycle and the discharging cycle is lower than the at least one capacity value estimated by at least one of the battery capacity estimation model and the data driven model. Further, the method includes correcting, by the electronic device, the forecasting RUL of the battery by feeding back the at least one capacity value to at least one of the battery capacity estimation model and the data driven model.

The method can be used to estimate health, detect anomaly, and predict remaining useful life without requiring any parameter tuning for new electronic devices. The method can be used to forecast future health trajectory using initial few cycle information. The method can be used to provide an efficient health prediction for assessing fitness of used batteries in market and evaluating competitor batteries. The method supports the online implementation feasibly as it requires less computation. The method can be used to correct the forecasted health as battery ages.

In the existing methods, the existing method cannot detect abnormal decay and forecasts once using initial degradation rate. The proposed method can be used to monitor battery health, detect anomaly, and corrects prediction based on the anomaly. In the existing methods, the method will not work for unseen battery that was not involved in training. The proposed method does not require retraining and easy to use.

In the existing methods, the existing method cannot be used for old batteries. The prediction rule is set using new cell data. The proposed method uses the recent data and forecasts the prediction. The proposed method does not use the hard defined rule/ threshold.

In the existing method, the method uses the separate modules for different tasks, such as health, anomaly, and prognosis. Hence, the existing method is computationally expensive. The proposed method can be used to determine health, level of anomaly, remaining useful life of the battery at one place. Hence, the proposed method requires less computation.

The existing method estimates the RUL once for a fresh cell, uses initial days data of the fresh cell to estimate RUL, but the existing method cannot re-estimate RUL if an anomaly occurs. The proposed method continuously monitors battery health and predicts RUL. The proposed method predicts RUL using past few days data of a battery irrespective of old or fresh cell and corrects RUL forecast if an anomaly occurs.

The method can be used to improve the user experience and avoids the surprise of the battery failure. The method can be used to ensure the user safety and avoid the accident by detecting anomaly. The method can be used to reduce the deployment time and effort, device agnostic approach.

The method can be used in an electronic device and a vehicle.

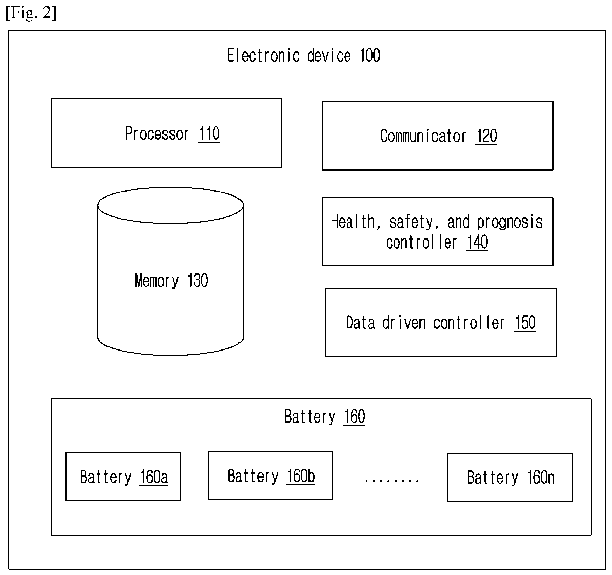

Referring now to the drawings, and more particularly to FIGS. 2, 3, 4, 5A to 5C, 6A to 6F, 7A to 7D, 8A to 8B, 9, 10A to 10I, 11, and 12, where similar reference characters denote corresponding features consistently throughout the figures, there are shown example embodiments.

FIG. 2 illustrates various hardware components of an electronic device 100 for forecasting RUL of a battery 160 according to an embodiment of the disclosure.

Referring to FIG. 2, the electronic device 100 can be, for example, but not limited to a laptop, a desktop computer, a notebook, a vehicle to everything (V2X) device, a smartphone, a tablet, an internet of things (IoT) device, an immersive device, a virtual reality device, a foldable device, or the like. The battery 160 can be, for example, but not limited to a lithium ion battery, a nickel-cadmium battery, a lead-acid battery, a lithium ion polymer battery, a nickel-metal hydride battery, a sodium-sulphur battery, a sodium-nickel chloride battery, a nickel-zinc battery, or the like.

In an embodiment of the disclosure, the electronic device 100 includes a processor 110, a communicator 120, a memory 130, a health, safety, and prognosis controller 140, a data driven controller 150 and a plurality of batteries 160a-160n. Hereafter, the label of the battery is 160. The processor 110 is coupled with the communicator 120, the memory 130, the health, safety, and prognosis controller 140, the data driven controller 150 and the battery 160.

The health, safety, and prognosis controller 140 measures at least one capacity value of the battery 160 for each charging cycle of the battery 160 and each discharging cycle of the battery 160. Further, the health, safety, and prognosis controller 140 estimates at least one capacity value of the battery 160 for subsequent charging cycles and subsequent discharging cycles using the at least one measured capacity value, wherein the at least one measured capacity value is provided to at least one of a battery capacity estimation model and a data driven model after a predefined number of charging cycles and a predefined number of discharging cycles. The predefined number of charging cycles and the predefined number of discharging cycles are configured by the user of the electronic device 100 or the original equipment manufacturer (OEM).

In an embodiment of the disclosure, the battery capacity estimation model is trained by a neural network (not shown) or the data driven controller 150 using the charge cycle and the discharge cycle. The battery capacity estimation model receives the charge cycle and the discharge cycle to compute a plurality of voltage, calculates a relative change in voltage from reference cycle of the battery and pass the plurality of voltage to a neural network to get a plurality of estimated SOH values.

The health, safety, and prognosis controller 140 forecasts the RUL of the battery 160 based on the at least one capacity value of the battery 160 estimated by the at least one of the battery capacity estimation model and the data driven model. Further, the health, safety, and prognosis controller 140 determines whether the at least one measured capacity value for the charging cycle and the discharging cycle is lower than the at least one capacity value estimated by at least one of the battery capacity estimation model and the data driven model. Further, the health, safety, and prognosis controller 140 corrects the forecasting RUL of the battery by feeding back the measured capacity value to at least one of the battery capacity estimation model and the data driven model.

Further, the health, safety, and prognosis controller 140 detects the level of the anomaly of the battery 160 when the measured battery capacity value is lower than the estimated battery capacity value by at least one of the battery capacity estimation model and the data driven model. The level of the anomaly can be, for example, but not limited to a low level of the anomaly, a high level of the anomaly, and a medium level of the anomaly.

Further, the health, safety, and prognosis controller 140 generates an alert including at least one of forecasted RUL, a battery replacement information, and a battery anomaly information based on the correction.

In an embodiment of the disclosure, the RUL of the battery 160 is forecasted as a number of charging cycles and discharging cycles subsequent to which the predicted battery capacity value is less than a predefined threshold. The predefined threshold is set by the user of the electronic device 100 and the OEM. In an example, a very commonly accepted threshold is 80% of the original capacity value. In a mobile phone for example if the RUL for an 80% threshold is less than 30 cycles, then the user of the mobile phone has 30 days to replace the battery assuming that 1 charge/discharge cycle is completed in 1 day.

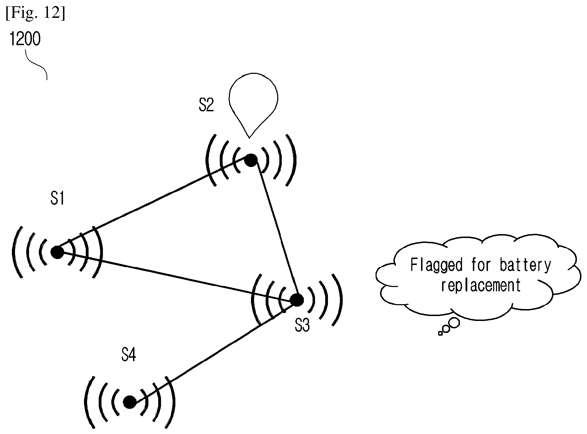

In an embodiment of the disclosure, the RUL for the battery 160 is forecasted in a connected environment. In an embodiment of the disclosure, the RUL forecast continuously monitors a health of the battery 160 and uses a feedback to correct the RUL forecast continuously (explained in the FIG. 12).

In an example, the charging data is used for immediate health assessment. The battery health is recorded for 150 cycles of sequential charging data, and complete future health trajectory is forecasted using that. After 150 cycles, battery health is continuously tracked as cycle advances, and the forecasted trajectory is corrected. The abuse/anomaly is detected when observed health deviates from the forecast. Hence, the proposed method is device agnostic. It can be used on any device in a real time.

In an example, for a fresh battery, the health, safety, and prognosis controller 140 monitors the battery cycles and samples the voltage and capacity. The health, safety, and prognosis controller 140 uses certain mathematical constructs to compute features from current and voltage signal of the present cycle (cycle 0). In an example, Vr=V-IR (R is assumed to be a constant value and V and I are charging data). The proposed method calculates the SOC by integrating I(t) and computes the increase in Vr with reference to a reference curve. Further, the health, safety, and prognosis controller 140 feeds the features to the battery capacity estimation model (no retraining for new device) to compute the SOH. The health, safety, and prognosis controller 140 continues estimating SOH for next 150 (chosen by analysis) cycles (i.e., cycle 1 - 150). Further, the health, safety, and prognosis controller 140 feeds the SOH of cycle 0 - 150 to a forecaster model (no retraining for new device) to predict SOH for cycle 150 - 300. Uses predicted SOH of cycles 150 - 300 to predict SOH for 300 - 450. Recursively forecasts for future cycles (150 cycles at a time) till end of battery life. The health, safety, and prognosis controller 140 determines extent of abuse (if any) by comparing running SOH and forecasted SOH. Further, the health, safety, and prognosis controller 140 corrects the forecast after anomaly. Further, the health, safety, and prognosis controller 140 identifies remaining useful life and future SOH trajectory using the forecast.

In an example, for the aged battery, the health, safety, and prognosis controller 140 monitors battery cycles, samples the voltage and capacity. Further, the health, safety, and prognosis controller 140 uses the certain mathematical constructs to compute features from current and voltage signal of the present cycle (cycle N). In an example, Vr=V-IR (R is assumed to be a constant value and V and I are charging data). The proposed method calculates the SOC by integrating I(t) and computes the increase in Vr with reference to a reference curve. Further, the health, safety, and prognosis controller 140 feeds the features to the battery capacity estimation model (no retraining for new device) to compute SOH. Further, the health, safety, and prognosis controller 140 continues estimating SOH for 150 (chosen by analysis) cycles (i.e., cycle N - N+150). Further, the health, safety, and prognosis controller 140 feeds the SOH of cycle N - N+150 to the forecaster model to predict SOH for cycle N+150 - N+300. Further, the health, safety, and prognosis controller 140 uses predicted SOH of cycles N+150 - N+300 to predict SOH for N+300 - N+450. Further, the health, safety, and prognosis controller 140 recursively forecasts for future cycles till end of battery life. Further, the health, safety, and prognosis controller 140 determines the extent of abuse (if any) by comparing running SOH and forecasted SOH. Corrects the forecast after anomaly. Identifies remaining useful life and future SOH trajectory using the forecast.

The health, safety, and prognosis controller 140 is physically implemented by analog or digital circuits, such as logic gates, integrated circuits, microprocessors, microcontrollers, memory circuits, passive electronic components, active electronic components, optical components, hardwired circuits, or the like, and may optionally be driven by firmware.

Further, the processor 110 is configured to execute instructions stored in the memory 130 and to perform various processes. The communicator 120 is configured for communicating internally between internal hardware components and with external devices via one or more networks. The memory 130 also stores instructions to be executed by the processor 110. The memory 130 may include non-volatile storage elements. Examples of such non-volatile storage elements may include magnetic hard discs, optical discs, floppy discs, flash memories, or forms of electrically programmable memories (EPROM) or electrically erasable and programmable (EEPROM) memories. In addition, the memory 130 may, in some examples, be considered a non-transitory storage medium. The term "non-transitory" may indicate that the storage medium is not embodied in a carrier wave or a propagated signal. However, the term "non-transitory" should not be interpreted that the memory 130 is non-movable. In certain examples, a non-transitory storage medium may store data that can, over time, change (e.g., in random access memory (RAM) or cache).

Further, at least one of the pluralities of modules/controller may be implemented through the artificial intelligence (AI) model using the data driven controller 150. The data driven controller 150 can be a machine learning (ML) model based controller and AI model based controller. The function associated with the AI model may be performed through the non-volatile memory, the volatile memory, and the processor 110. The processor 110 may include one or a plurality of processors. At this time, one or a plurality of processors may be a general purpose processor, such as a central processing unit (CPU), an application processor (AP), or the like, a graphics-only processing unit, such as a graphics processing unit (GPU), a visual processing unit (VPU), and/or an AI-dedicated processor, such as a neural processing unit (NPU).

The one or a plurality of processors control the processing of the input data in accordance with a predefined operating rule or AI model stored in the non-volatile memory and the volatile memory. The predefined operating rule or artificial intelligence model is provided through training or learning.

Here, being provided through learning means that a predefined operating rule or AI model of a desired characteristic is made by applying a learning algorithm to a plurality of learning data. The learning may be performed in a device itself in which AI according to an embodiment is performed, and/o may be implemented through a separate server/system.

The AI model may comprise of a plurality of neural network layers. Each layer has a plurality of weight values, and performs a layer operation through calculation of a previous layer and an operation of a plurality of weights. Examples of neural networks include, but are not limited to, convolutional neural network (CNN), deep neural network (DNN), recurrent neural network (RNN), restricted Boltzmann machine (RBM), deep belief network (DBN), bidirectional recurrent deep neural network (BRDNN), generative adversarial networks (GAN), and deep Q-networks.

The learning algorithm is a method for training a predetermined target device (for example, a robot) using a plurality of learning data to cause, allow, or control the target device to make a determination or prediction. Examples of learning algorithms include, but are not limited to, supervised learning, unsupervised learning, semi-supervised learning, or reinforcement learning.

Although FIG. 2 illustrates various hardware components of the electronic device 100 but it is to be understood that other embodiments are not limited thereon. In other embodiments of the disclosure, the electronic device 100 may include less or more number of components. Further, the labels or names of the components are used only for illustrative purpose and does not limit the scope of the disclosure. One or more components can be combined together to perform same or substantially similar function in the electronic device 100.

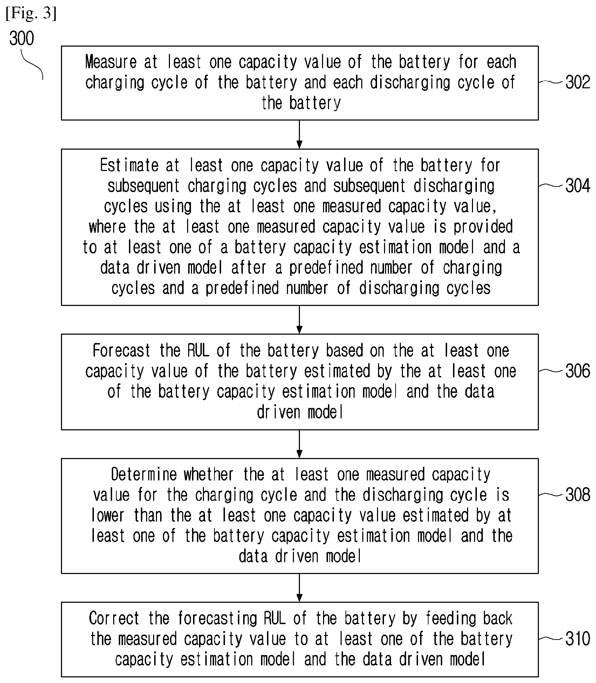

FIG. 3 is a flowchart 300 illustrating a method for forecasting the RUL of a battery 160 according to an embodiment of the disclosure. The operations 302-310 are handled by the health, safety, and prognosis controller 140.

At operation 302, the method includes measuring the at least one capacity value of the battery 160 for each charging cycle of the battery 160 and each discharging cycle of the battery 160. At operation 304, the method includes estimating the at least one capacity value of the battery 160 for subsequent charging cycles and subsequent discharging cycles using the at least one measured capacity value, wherein the at least one measured capacity value is provided to at least one of the battery capacity estimation model and the data driven model after the predefined number of charging cycles and the predefined number of discharging cycles. At operation 306, the method includes forecasting the RUL of the battery 160 based on the at least one capacity value of the battery 160 estimated by at least one of the battery capacity estimation model and the data driven model.

At operation 308, the method includes determining whether the at least one measured capacity value for the charging cycle and the discharging cycle is lower than the at least one capacity value estimated by at least one of the battery capacity estimation model and the data driven model. At operation 310, the method includes correcting the forecasting RUL of the battery 160 by feeding back the measured capacity value to at least one of the battery capacity estimation model and the data driven model.

The method can be used to estimate health, detect anomaly, and predict remaining useful life without requiring any parameter tuning for new electronic devices. The method can be used to forecast future health trajectory using initial few cycle information. The method can be used to provide an efficient health prediction for assessing fitness of used batteries in market and evaluating competitor batteries. The method supports the online implementation feasibly as it requires less computation. The method can be used to correct the forecasted health as battery ages.

In the existing methods, the existing method cannot detect abnormal decay, forecasts once using initial degradation rate. The proposed method can be used to monitors battery health and detects anomaly, and corrects prediction based on the anomaly. In the existing methods, the method will not work for unseen battery that was not involved in training. The proposed method does not require retraining and easy to use.

In the existing methods, the existing method cannot be used for old batteries. The prediction rule is set using new cell data. The proposed method uses the recent data and forecasts the prediction. The proposed method does not use the hard defined rule/ threshold.

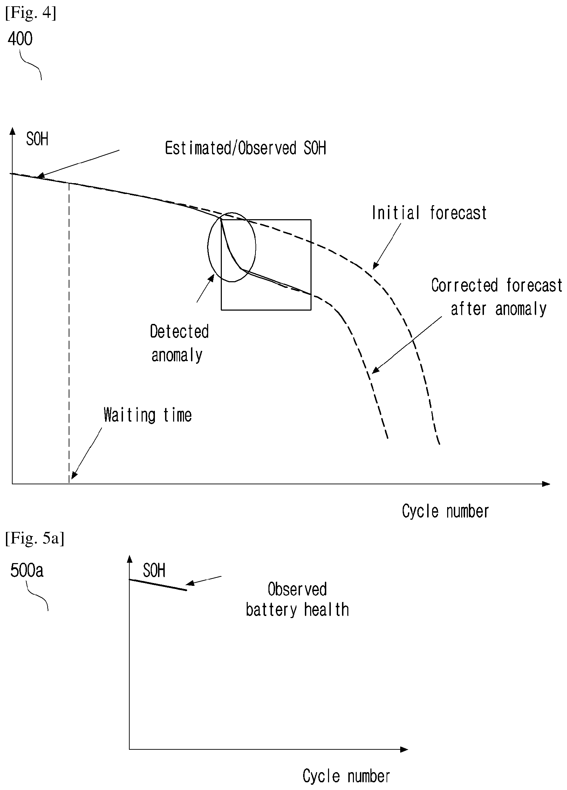

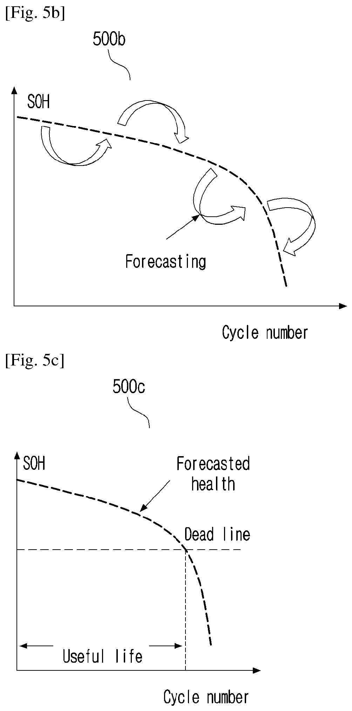

FIGS. 4, 5A, 5B, and 5C are graph illustrations 400 and 500a-500c in which the electronic device 100 forecasts the RUL of the battery 160 according to various embodiments of the disclosure.

Referring to FIG. 4, the proposed method provides the feedback between the estimated SOH and the forecasted SOH, so as to detect the extent of the anomaly from deviation in observed health from the forecasted reference. The method improves the user experience and avoids the sudden battery failure. The proposed method ensures user safety.

Referring to FIG. 5A, the method can be used to measure voltage and current @ charging cycle to compute health of the battery 160. Referring to FIG. 5B, the method can be used to forecast health at all future cycles using the observed health at present and limited past cycles of the battery 160. Referring to FIG. 5C, the method can be used to complete future health trajectory and remain the useful life of the battery 160.

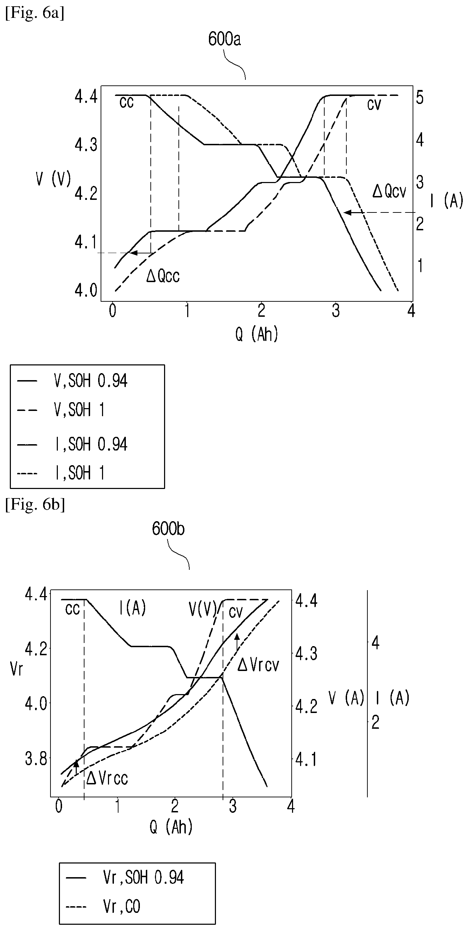

FIGS. 6A and 6B are graph illustrations 600a and 600b in which customized SOH estimation is depicted according to various embodiments of the disclosure.

Referring to FIGS. 6A and 6B, the health, safety, and prognosis controller 140 computes Q (integral of current) and Vr (V-IR). The health, safety, and prognosis controller 140 calculates drop in Q (△Q) and rise in Vr (△Vr) with respect to fresh battery (cycle 0) at fixed voltage during constant current (CC). The health, safety, and prognosis controller 140 computes drop in Q (△Q) and rise in Vr (△Vr) with respect to the fresh battery (cycle 0) at the fixed Current during constant voltage (CV). The health, safety, and prognosis controller 140 estimates the drop in SOH using △Q and △Vr.

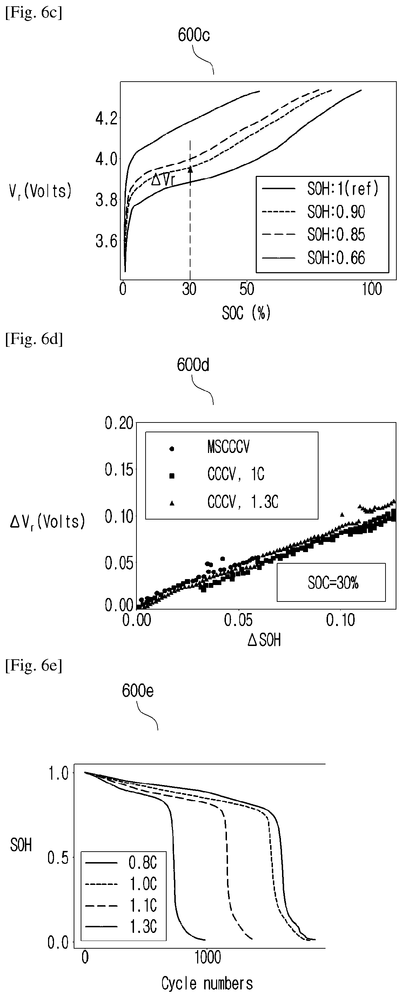

FIGS. 6C and 6D are graph illustrations 600c and 600d in which device-agnostic SOH estimation is depicted according to various embodiments of the disclosure.

Referring to FIGS. 6C and 6D, the health, safety, and prognosis controller 140 computes Vr (V-IR) and SOC (Q/rated capacity). The health, safety, and prognosis controller 140 computes the rise in Vr (△V) with respect to the reference curve at the fixed SOC and estimates the drop in SOH from (△Vr).

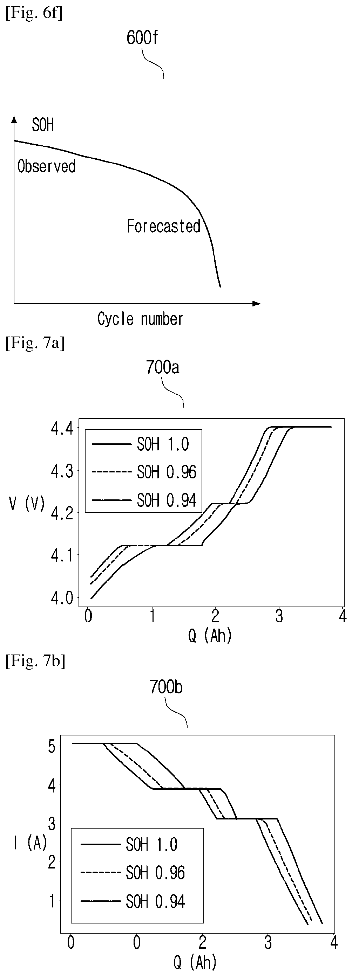

FIGS. 6E and 6F are graph illustrations 600e and 600f in which SOH forecast is depicted according to various embodiments of the disclosure.

Referring to FIGS. 6C and 6D, the health, safety, and prognosis controller 140 estimates SOH for 0-150 cycles. The health, safety, and prognosis controller 140 extrapolates SOH for cycle 0-150 and predicts for 150-300. The health, safety, and prognosis controller 140 extrapolates SOH for cycle 150-300 and predict for 300-450. The health, safety, and prognosis controller 140 continues to predict recursively till battery end of life.

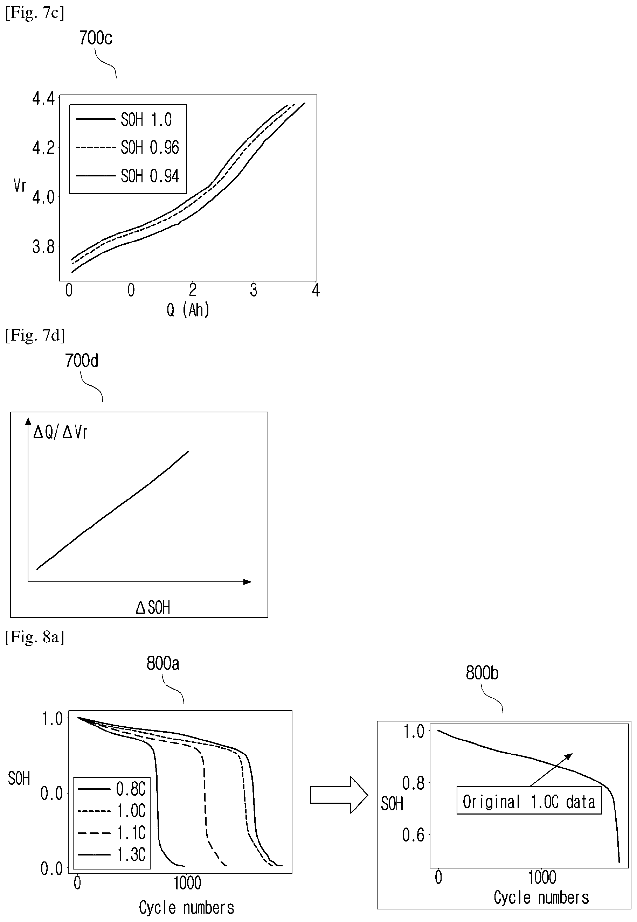

FIGS. 7A to 7D are illustrations 700a-700d in which battery health degrade is depicted based on Q-V, Q-I, and Q-Vr/SOC-Vr curve drift according to various embodiments of the disclosure.

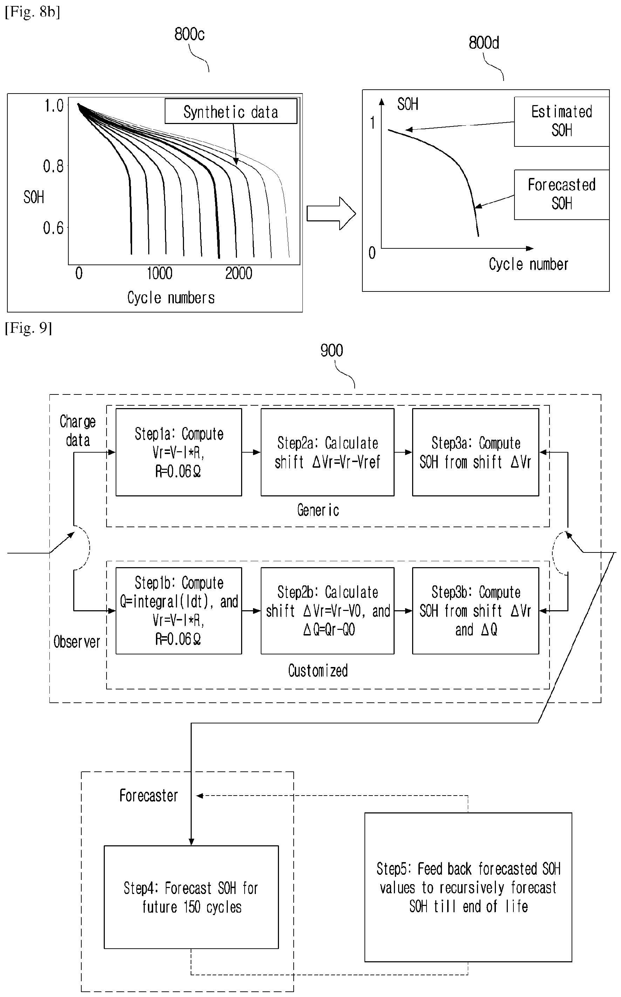

FIGS. 8A and 8B are illustrations 800a-800d in which health trajectory of batteries cycled at different C-rates follow a pattern and start separating after initial few cycles according to various embodiments of the disclosure.

FIG. 9 is an flowchart illustrating various operations 1000a-1000i for forecasting a RUL of a battery according to an embodiment of the disclosure.

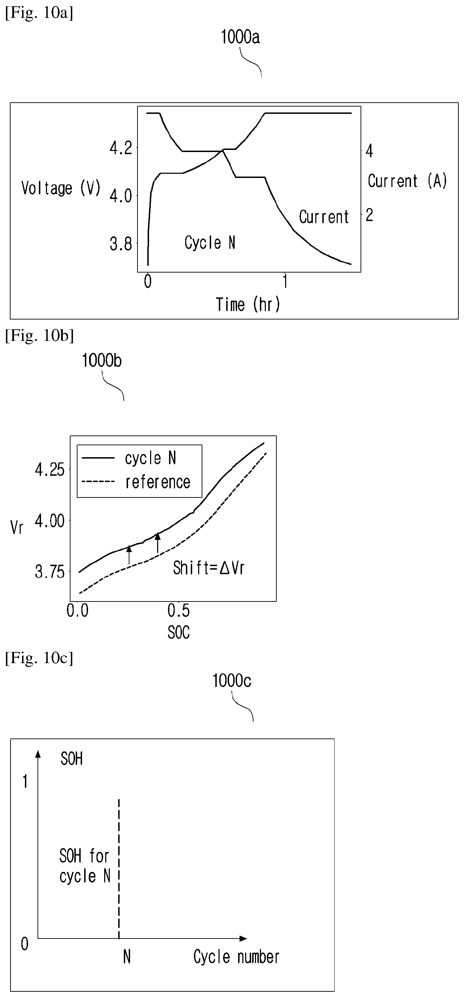

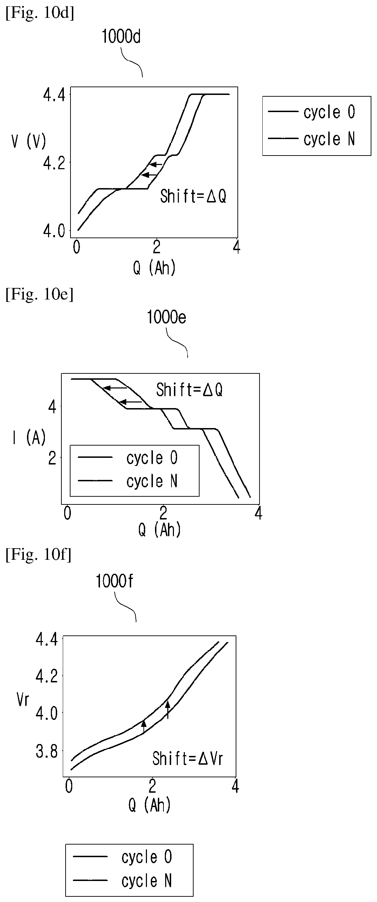

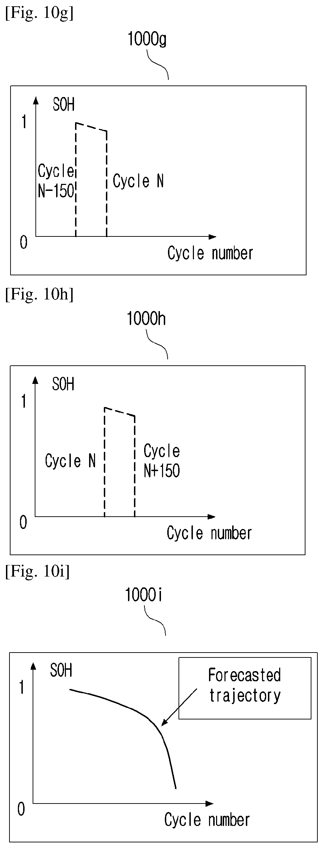

FIGS. 10A, 10B, 10C, 10D, 10E, 10F, 10G, 10H, and 10I are illustrations 1000a-1000i in which RUL of the battery 160 is determined in connection with FIG. 9 according to various embodiments of the disclosure.

Referring to FIG. 7A, 7B, 7C, 7D, 8A, 8B, 8C, 8D, 9, 10A, 10B, 10C, 10D, 10E, 10F, 10G, 10H, 10I, at operation 1a, the method computes Vr=V-I*R (as shown in the FIG. 10A), where R=0.06Ω. At operation 2a, the method computes the shift △ Vr=Vr-Vref as shown in the FIG. 10B. At operation 3a, the method computes the SOH from shift △Vr as shown in the FIG. 10C.

At operation 1b, the method computes Q=integral (Idt), and Vr=V-I*R as shown in FIG. 10D. At operation 2b, the method calculates shift △Vr=Vr-V0, and △Q=Qr-Q0 as shown in FIG. 10E. At operation 3b, the method computes SOH from shift △Vr and △Q as shown in FIG. 10F. At operation 4, the method forecast SOH for future 150 cycles (as shown in FIGS. 10G and 10H). At operation 5, the method feeds back forecasted SOH values to recursively forecast SOH till end of life.

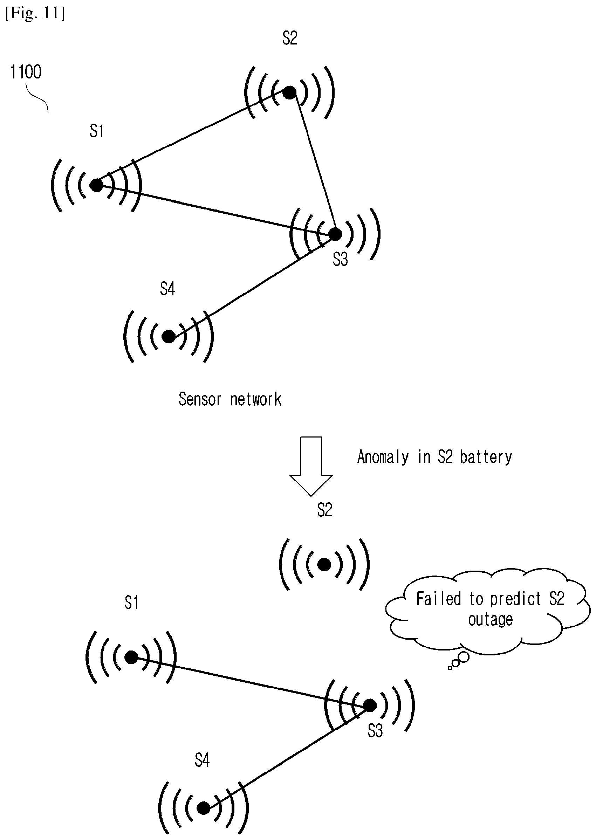

FIG. 11 is an illustration 1100 in which safe use of sensor networks is depicted according to related art. The existing method provides the unreliable prediction without on device health monitor.

FIG. 12 is an illustration 1200 in which safe use of sensor networks is depicted according to an embodiment of the disclosure. The proposed method monitors the battery 160 and forecasts accordingly.

Referring to FIG. 11 and 12, the various actions, acts, blocks, steps, or the like, in the flowcharts 300 and 900 may be performed in the order presented, in a different order or simultaneously. Further, in some embodiments of the disclosure, some of the actions, acts, blocks, steps, or the like, may be omitted, added, modified, skipped, or the like, without departing from the scope of the disclosure.

The embodiments disclosed herein can be implemented through at least one software program running on at least one hardware device and performing network management functions to control the elements.

While the disclosure has been shown and described with reference to various embodiments thereof, it will be understood by those skilled in the art that various changes in form and details may be made therein without departing from the scope of the disclosure as defined by the appended claims.

## Claims

1. A method for forecasting remaining useful life, RUL, of a battery (160), the method comprising:
measuring, by an electronic device (100), at least one capacity value of the battery for each charging cycle of the battery and each discharging cycle of the battery;
estimating, by the electronic device, at least one capacity value of the battery for subsequent charging cycles and subsequent discharging cycles using the at least one capacity value, wherein the at least one capacity value is provided to at least one of a battery capacity estimation model and a data driven model after a predefined number of charging cycles and a predefined number of discharging cycles;
forecasting, by the electronic device, the RUL of the battery based on the at least one capacity value of the battery estimated by at least one of the battery capacity estimation model and the data driven model;
determining, by the electronic device, whether the at least one capacity value for the charging cycle and the discharging cycle is lower than the at least one capacity value estimated by at least one of the battery capacity estimation model and the data driven model; and
correcting, by the electronic device, the forecasting RUL of the battery by feeding back the measured at least one capacity value to at least one of the battery capacity estimation model and the data driven model.

2. The method of claim 1, further comprising:
detecting, by the electronic device, a level of an anomaly of the battery when the at least one capacity value of the battery is lower than the estimated battery capacity value by at least one of the battery capacity estimation model and the data driven model.

3. The method of claim 1, further comprising:
generating, by the electronic device, an alert including at least one of forecasted RUL, a battery replacement information, and a battery anomaly information based on the correcting of the forecasting RUL of the battery.

4. The method of claim 1,
wherein the battery capacity estimation model is trained by a neural network using a charge cycle and a discharge cycle, and
wherein the battery capacity estimation model receives the charge cycle and the discharge cycle to compute a plurality of voltage, calculates a relative change in voltage from reference cycle of the battery and pass the plurality of voltage to a neural network to get a plurality of estimated state of health (SOH) values.

5. The method of claim 1, wherein the RUL of the battery is forecasted as a number of charging cycles and discharging cycles subsequent to which a predicted battery capacity value is less than a predefined threshold.

6. The method of claim 1, wherein the RUL for the battery is forecasted in a connected environment.

7. The method of claim 1, wherein the RUL forecast continuously monitors a health of the battery and uses a feedback to correct the RUL forecast continuously.

8. An electronic device (100) comprising:
at least one processor (110);
a memory (130); and
a health, safety, and prognosis controller (140), coupled with the at least one processor and the memory, configured to:
measure at least one capacity value of a battery (160) for each charging cycle of the battery and each discharging cycle of the battery, estimate at least one capacity value of the battery for subsequent charging cycles and subsequent discharging cycles using the at least one capacity value, wherein the at least one capacity value is provided to at least one of a battery capacity estimation model and a data driven model after a predefined number of charging cycles and a predefined number of discharging cycles, forecast remaining useful life, RUL, of the battery based on the at least one capacity value of the battery estimated by the at least one of the battery capacity estimation model and the data driven model, determine whether the at least one capacity value for the charging cycle and the discharging cycle is lower than the at least one capacity value estimated by at least one of the battery capacity estimation model and the data driven model, and correct the forecasting RUL of the battery by feeding back the measured at least one capacity value to at least one of the battery capacity estimation model and the data driven model.

9. The electronic device of claim 8, wherein the health, safety, and prognosis controller is further configured to detect a level of an anomaly of the battery when the at least one capacity value of the battery is lower than the estimated battery capacity value by at least one of the battery capacity estimation model and the data driven model.

10. The electronic device of claim 8, wherein the health, safety, and prognosis controller is further configured to generate an alert including at least one of forecasted RUL, a battery replacement information, and a battery anomaly information based on correction of the forecasting RUL of the battery.

11. The electronic device of claim 8,
wherein the battery capacity estimation model is trained by a neural network using a charge cycle and a discharge cycle, and
wherein the battery capacity estimation model receives the charge cycle and the discharge cycle to compute a plurality of voltage, calculates a relative change in voltage from reference cycle of the battery and pass the plurality of voltage to a neural network to get a plurality of estimated state of health (SOH) values.

12. The electronic device of claim 8, wherein the RUL of the battery is forecasted as a number of charging cycles and discharging cycles subsequent to which a predicted battery capacity value is less than a predefined threshold.

13. The electronic device of claim 8, wherein the RUL for the battery is forecasted in a connected environment.

14. The electronic device of claim 8, wherein the RUL forecast continuously monitors a health of the battery and uses a feedback to correct the RUL forecast continuously.

15. A non-transitory computer readable recording medium storing a program for executing an operating method, the operation method including:
measuring, by an electronic device (100), at least one capacity value of a battery (160) for each charging cycle of the battery and each discharging cycle of the battery;
estimating, by the electronic device, at least one capacity value of the battery for subsequent charging cycles and subsequent discharging cycles using the at least one capacity value, wherein the at least one capacity value is provided to at least one of a battery capacity estimation model and a data driven model after a predefined number of charging cycles and a predefined number of discharging cycles;
forecasting, by the electronic device, the remaining useful life, RUL, of the battery based on the at least one capacity value of the battery estimated by at least one of the battery capacity estimation model and the data driven model; determining, by the electronic device, whether the at least one capacity value for the charging cycle and the discharging cycle is lower than the at least one capacity value estimated by at least one of the battery capacity estimation model and the data driven model; and
correcting, by the electronic device, the forecasting RUL of the battery by feeding back the measured at least one capacity value to at least one of the battery capacity estimation model and the data driven model.

## Patentansprüche

1. Verfahren zum Vorhersagen der verbleibenden Nutzungslebensdauer, RUL, einer Batterie (160), wobei das Verfahren umfasst:
Messen mindestens eines Kapazitätswerts der Batterie durch eine elektronische Vorrichtung (100) für jeden Ladezyklus der Batterie und jeden Entladezyklus der Batterie;
Schätzen mindestens eines Kapazitätswerts der Batterie für nachfolgende Ladezyklen und nachfolgende Entladezyklen durch die elektronische Vorrichtung unter Verwendung des mindestens einen Kapazitätswerts, wobei der mindestens eine Kapazitätswert nach einer vordefinierten Anzahl von Ladezyklen und einer vordefinierten Anzahl von Entladezyklen von zumindest einem eines Batteriekapazitätsschätzungsmodells und eines datengesteuerten Modells bereitgestellt wird;
Vorhersagen der RUL der Batterie durch die elektronische Vorrichtung basierend auf dem mindestens einen Kapazitätswert der Batterie, der durch das mindestens eine des Batteriekapazitätsschätzungsmodells und des datengesteuerten Modells geschätzt wird;
Bestimmen, durch die elektronische Vorrichtung, ob der mindestens eine Kapazitätswert für den Ladezyklus und den Entladezyklus niedriger ist als der mindestens eine Kapazitätswert, der durch mindestens eines von dem Batteriekapazitätsschätzungsmodell und dem datengesteuerten Modell geschätzt wird; und
Korrigieren der vorhergesagten RUL der Batterie durch die elektronische Vorrichtung, durch Rückmelden des gemessenen mindestens einen Kapazitätswerts an das mindestens eine des Batteriekapazitätsschätzungsmodells und des datengesteuerten Modells.

2. Verfahren nach Anspruch 1, ferner umfassend:
Erfassen, durch die elektronische Vorrichtung, eines Niveaus einer Anomalie der Batterie, wenn der mindestens eine Kapazitätswert der Batterie niedriger ist als der geschätzte Batteriekapazitätswert durch mindestens eines von dem Batteriekapazitätsschätzungsmodell und dem datengesteuerten Modell.

3. Verfahren nach Anspruch 1, ferner umfassend:
Erzeugen einer Warnung durch die elektronische Vorrichtung, die zumindest eine einer prognostizierten RUL, einer Batterieaustauschinformation und einer Batterieanomalieinformation umfasst, basierend auf dem Korrigieren der vorhergesagten RUL der Batterie.

4. Verfahren nach Anspruch 1,
wobei das Batteriekapazitätsschätzungsmodell durch ein neuronales Netzwerk unter Verwendung eines Ladezyklus und eines Entladezyklus trainiert wird, und
wobei das Batteriekapazitätsschätzungsmodell den Ladezyklus und den Entladezyklus empfängt, um eine Vielzahl von Spannungen zu berechnen, eine relative Änderung der Spannung gegenüber dem Referenzzyklus der Batterie berechnet und die Vielzahl von Spannungen an ein neuronales Netzwerk weiterleitet, um eine Vielzahl von geschätzten Gesundheitszustands-(SOH)-Werten zu erhalten.

5. Verfahren nach Anspruch 1, wobei die RUL der Batterie als eine Anzahl von Ladezyklen und Entladezyklen vorhergesagt wird, nach denen ein vorhergesagter Batteriekapazitätswert kleiner als ein vordefinierter Schwellenwert ist.

6. Verfahren nach Anspruch 1, wobei die RUL für die Batterie in einer verbundenen Umgebung vorhergesagt wird.

7. Verfahren nach Anspruch 1, wobei die RUL-Vorhersage kontinuierlich einen Gesundheitszustand der Batterie überwacht und eine Rückmeldung verwendet, um die RUL-Vorhersage kontinuierlich zu korrigieren.

8. Elektronische Vorrichtung (100), umfassend:
mindestens einen Prozessor (110);
einen Speicher (130); und
eine Gesundheits-, Sicherheits- und Prognosesteuerung (140), die mit dem mindestens einen Prozessor und dem Speicher gekoppelt ist und konfiguriert ist zum:
Messen mindestens eines Kapazitätswerts einer Batterie (160) für jeden Ladezyklus der Batterie und jeden Entladezyklus der Batterie,
Schätzen mindestens eines Kapazitätswerts der Batterie für nachfolgende Ladezyklen und nachfolgende Entladezyklen unter Verwendung des mindestens einen Kapazitätswerts, wobei der mindestens eine Kapazitätswert nach einer vordefinierten Anzahl von Ladezyklen und einer vordefinierten Anzahl von Entladezyklen einem eines Batteriekapazitätsschätzungsmodells und eines datengesteuerten Modells bereitgestellt wird,
Vorhersagen der verbleibenden Nutzungslebensdauer, RUL der Batterie basierend auf dem mindestens einen Kapazitätswert der Batterie, der durch das mindestens eine des Batteriekapazitätsschätzungsmodells und des datengesteuerten Modells geschätzt wird,
Bestimmen, ob der mindestens eine Kapazitätswert für den Ladezyklus und den Entladezyklus niedriger ist als der mindestens eine Kapazitätswert, der durch mindestens eines von dem Batteriekapazitätsschätzungsmodell und dem datengesteuerten Modell geschätzt wird, und
Korrigieren der vorhergesagten RUL der Batterie durch Rückmelden des gemessenen mindestens einen Kapazitätswerts an das mindestens eine des Batteriekapazitätsschätzungsmodells und des datengesteuerten Modells.

9. Elektronische Vorrichtung nach Anspruch 8, wobei die Gesundheits-, Sicherheits- und Prognosesteuerung ferner konfiguriert ist, um ein Niveau einer Anomalie der Batterie zu erfassen, wenn der mindestens eine Kapazitätswert der Batterie niedriger ist als der geschätzte Batteriekapazitätswert durch mindestens eines von dem Batteriekapazitätsschätzungsmodell und dem datengesteuerten Modell.

10. Elektronische Vorrichtung nach Anspruch 8, wobei die Gesundheits-, Sicherheits- und Prognosesteuerung ferner konfiguriert ist zum Erzeugen einer Warnung, die zumindest eine einer prognostizierten RUL, einer Batterieaustauschinformation und einer Batterieanomalieinformation umfasst, basierend auf der Korrektur der vorhergesagten RUL der Batterie.

11. Elektronische Vorrichtung nach Anspruch 8,
wobei das Batteriekapazitätsschätzungsmodell durch ein neuronales Netzwerk unter Verwendung eines Ladezyklus und eines Entladezyklus trainiert wird, und
wobei das Batteriekapazitätsschätzungsmodell den Ladezyklus und den Entladezyklus empfängt, um eine Vielzahl von Spannungen zu berechnen, eine relative Änderung der Spannung gegenüber dem Referenzzyklus der Batterie berechnet und die Vielzahl von Spannungen an ein neuronales Netzwerk weiterleitet, um eine Vielzahl von geschätzten Gesundheitszustands-(SOH)-Werten zu erhalten.

12. Elektronische Vorrichtung nach Anspruch 8, wobei die RUL der Batterie als eine Anzahl von Ladezyklen und Entladezyklen vorhergesagt wird, nach denen ein vorhergesagter Batteriekapazitätswert kleiner als ein vordefinierter Schwellenwert ist.

13. Elektronische Vorrichtung nach Anspruch 8, wobei die RUL für die Batterie in einer verbundenen Umgebung vorhergesagt wird.

14. Elektronische Vorrichtung nach Anspruch 8, wobei die RUL-Vorhersage kontinuierlich einen Gesundheitszustand der Batterie überwacht und eine Rückmeldung verwendet, um die RUL-Vorhersage kontinuierlich zu korrigieren.

15. Nicht-transitorisches, computerlesbares Aufzeichnungsmedium, das ein Programm zum Ausführen eines Betriebsverfahrens speichert, wobei das Betriebsverfahren umfasst:
Messen mindestens eines Kapazitätswerts der Batterie durch eine elektronische Vorrichtung für jeden Ladezyklus der Batterie und jeden Entladezyklus der Batterie;
Schätzen mindestens eines Kapazitätswerts der Batterie für nachfolgende Ladezyklen und nachfolgende Entladezyklen durch die elektronische Vorrichtung unter Verwendung des mindestens einen Kapazitätswerts, wobei der mindestens eine Kapazitätswert nach einer vordefinierten Anzahl von Ladezyklen und einer vordefinierten Anzahl von Entladezyklen von zumindest einem eines Batteriekapazitätsschätzungsmodells und eines datengesteuerten Modells bereitgestellt wird;
Vorhersagen der RUL der Batterie durch die elektronische Vorrichtung basierend auf dem mindestens einen Kapazitätswert der Batterie, der durch das mindestens eine des Batteriekapazitätsschätzungsmodells und des datengesteuerten Modells geschätzt wird;
Bestimmen, durch die elektronische Vorrichtung, ob der mindestens eine Kapazitätswert für den Ladezyklus und den Entladezyklus niedriger ist als der mindestens eine Kapazitätswert, der durch mindestens eines von dem Batteriekapazitätsschätzungsmodell und dem datengesteuerten Modell geschätzt wird; und
Korrigieren der vorhergesagten RUL der Batterie durch die elektronische Vorrichtung, durch Rückmelden des gemessenen mindestens einen Kapazitätswerts an das mindestens eine des Batteriekapazitätsschätzungsmodells und des datengesteuerten Modells.

## Revendications

1. Procédé de prévision de la durée de vie utile restante, RUL, d'une batterie (160), comprenant :
mesurer, par un dispositif électronique (100), au moins une valeur de capacité de la batterie pour chaque cycle de charge de la batterie et chaque cycle de décharge de la batterie ;
estimer, par le dispositif électronique, au moins une valeur de capacité de la batterie pour des cycles de charge suivants et des cycles de décharge suivants à l'aide d'au moins une valeur de capacité, dans lequel l'au moins une valeur de capacité est fournie à au moins l'un d'un modèle d'estimation de la capacité de la batterie et d'un modèle axé sur les données après un nombre prédéfini de cycles de charge et un nombre prédéfini de cycles de décharge ;
prévoir, par le dispositif électronique, la RUL de la batterie sur la base de l'au moins une valeur de capacité de la batterie estimée par au moins l'un du modèle d'estimation de la capacité de la batterie et du modèle axé sur les données ;
déterminer, par le dispositif électronique, si l'au moins une valeur de capacité pour le cycle de charge et le cycle de décharge est inférieure à l'au moins une valeur de capacité estimée par au moins l'un du modèle d'estimation de la capacité de la batterie et du modèle axé sur les données ; et
corriger, par le dispositif électronique, la prévision de la RUL de la batterie en renvoyant l'au moins une valeur de capacité mesurée à l'au moins un du modèle d'estimation de la capacité de la batterie et du modèle axé sur les données.

2. Procédé de la revendication 1, comprenant en outre :
détecter, par le dispositif électronique, un niveau d'anomalie de la batterie lorsque l'au moins une valeur de capacité de la batterie est inférieure à la valeur de capacité de batterie estimée par au moins l'un du modèle d'estimation de la capacité de la batterie et du modèle axé sur les données.

3. Procédé de la revendication 1, comprenant en outre :
générer, par le dispositif électronique, une alerte comprenant au moins une de RUL prévues, d'informations de remplacement de la batterie, et d'informations d'anomalie de la batterie en se basant sur la correction de la RUL prévue de la batterie.

4. Procédé de la revendication 1,
dans lequel le modèle d'estimation de la capacité de la batterie est entraîné par un réseau neuronal à l'aide d'un cycle de charge et d'un cycle de décharge, et
dans lequel le modèle d'estimation de la capacité de la batterie reçoit le cycle de charge et le cycle de décharge pour calculer une pluralité de tensions, calcule un changement relatif de tension par rapport au cycle de référence de la batterie et transmet la pluralité de tensions à un réseau neuronal pour obtenir une pluralité de valeurs estimées d'état de santé, SOH.

5. Procédé de la revendication 1, dans lequel la RUL de la batterie est prévue comme un nombre de cycles de charge et de cycles de décharge après lesquels une valeur prédite de la capacité de la batterie est inférieure à un seuil prédéfini.

6. Procédé de la revendication 1, dans lequel la RUL de la batterie est prévue dans un environnement connecté.

7. Procédé de la revendication 1, dans lequel la prévision de RUL surveille en permanence l'état de santé de la batterie et utilise un retour pour corriger en permanence la prévision de RUL.

8. Dispositif électronique (100), comprenant :
au moins un processeur (110) ;
une mémoire (130) ; et
une commande de santé, de sécurité et de pronostic (140), couplée à l'au moins un processeur et à la mémoire, configuré pour :
mesurer au moins une valeur de capacité d'une batterie (160) pour chaque cycle de charge de la batterie et chaque cycle de décharge de la batterie,
estimer au moins une valeur de capacité de la batterie pour des cycles de charge suivants et des cycles de décharge suivants à l'aide d'au moins une valeur de capacité, dans lequel l'au moins une valeur de capacité est fournie à au moins l'un d'un modèle d'estimation de la capacité de la batterie et d'un modèle axé sur les données après un nombre prédéfini de cycles de charge et un nombre prédéfini de cycles de décharge,
prévoir la RUL de la batterie sur la base de l'au moins une valeur de capacité de la batterie estimée par au moins l'un du modèle d'estimation de la capacité de la batterie et du modèle axé sur les données,
détermine si l'au moins une valeur de capacité pour le cycle de charge et le cycle de décharge est inférieure à l'au moins une valeur de capacité estimée par au moins l'un du modèle d'estimation de la capacité de la batterie et du modèle axé sur les données, et
corriger la prévision de la RUL de la batterie en renvoyant l'au moins une valeur de capacité mesurée à l'au moins un du modèle d'estimation de la capacité de la batterie et du modèle axé sur les données.

9. Dispositif électronique de la revendication 8, dans lequel la commande de santé, de sécurité et de pronostic est en outre configuré pour détecter un niveau d'anomalie de la batterie lorsque l'au moins une valeur de capacité de la batterie est inférieure à la valeur de capacité estimée de la batterie par au moins l'un du modèle d'estimation de la capacité de la batterie et du modèle axé sur les données.

10. Dispositif électronique de la revendication 8, dans lequel la commande de santé, de sécurité et de pronostic est en outre configuré pour générer une alerte comprenant au moins une de RUL prévues, d'informations de remplacement de la batterie, et d'informations d'anomalie de la batterie en se basant sur la correction de la RUL prévue de la batterie.

11. Dispositif électronique de la revendication 8,
dans lequel le modèle d'estimation de la capacité de la batterie est entraîné par un réseau neuronal à l'aide d'un cycle de charge et d'un cycle de décharge, et
dans lequel le modèle d'estimation de la capacité de la batterie reçoit le cycle de charge et le cycle de décharge pour calculer une pluralité de tensions, calcule un changement relatif de tension par rapport au cycle de référence de la batterie et transmet la pluralité de tensions à un réseau neuronal pour obtenir une pluralité de valeurs estimées d'état de santé, SOH.

12. Dispositif électronique de la revendication 8, dans lequel la RUL de la batterie est prévue comme un nombre de cycles de charge et de cycles de décharge après lesquels une valeur prédite de la capacité de la batterie est inférieure à un seuil prédéfini.

13. Dispositif électronique de la revendication 8, dans lequel la RUL de la batterie est prévue dans un environnement connecté.

14. Dispositif électronique de la revendication 8, dans lequel la prévision de RUL surveille en permanence la santé de la batterie et utilise une rétroaction pour corriger en permanence la prévision de RUL.

15. Support d'enregistrement non transitoire lisible par ordinateur stockant un programme pour exécuter un procédé d'exploitation, le procédé d'exploitation comprenant :
mesurer, par un dispositif électronique, au moins une valeur de capacité de la batterie pour chaque cycle de charge de la batterie et chaque cycle de décharge de la batterie ;
estimer, par le dispositif électronique, au moins une valeur de capacité de la batterie pour des cycles de charge suivants et des cycles de décharge suivants à l'aide d'au moins une valeur de capacité, dans lequel l'au moins une valeur de capacité est fournie à au moins l'un d'un modèle d'estimation de la capacité de la batterie et d'un modèle axé sur les données après un nombre prédéfini de cycles de charge et un nombre prédéfini de cycles de décharge ;
prévoir, par le dispositif électronique, la RUL de la batterie sur la base de l'au moins une valeur de capacité de la batterie estimée par au moins l'un du modèle d'estimation de la capacité de la batterie et du modèle axé sur les données ;
déterminer, par le dispositif électronique, si l'au moins une valeur de capacité pour le cycle de charge et le cycle de décharge est inférieure à l'au moins une valeur de capacité estimée par au moins l'un du modèle d'estimation de la capacité de la batterie et du modèle axé sur les données ; et
corriger, par le dispositif électronique, la prévision de la RUL de la batterie en renvoyant l'au moins une valeur de capacité mesurée à l'au moins un du modèle d'estimation de la capacité de la batterie et du modèle axé sur les données.
